(19) Europäisches Patentamt
European Patent Office
Office européen des brevets

(11) **EP 2 251 708 A1**

(12) **EUROPEAN PATENT APPLICATION**

(43) Date of publication:
**17.11.2010 Bulletin 2010/46**

(51) Int Cl.:
*G01S 7/491* (2006.01)       *G01S 17/32* (2006.01)
*H03K 17/94* (2006.01)

(21) Application number: **09006286.0**

(22) Date of filing: **08.05.2009**

(84) Designated Contracting States:
**AT BE BG CH CY CZ DE DK EE ES FI FR GB GR
HR HU IE IS IT LI LT LU LV MC MK MT NL NO PL
PT RO SE SI SK TR**
Designated Extension States:
**AL BA RS**

(71) Applicant: **Yamatake Corporation
Tokyo 100-6419 (JP)**

(72) Inventor: **Ueno, Tatsuya
Tokyo 100-6419 (JP)**

(74) Representative: **Samson & Partner
Widenmayerstrasse 5
80538 München (DE)**

(54) **Reflective photoelectric switch and object detection method**

(57)      A reflective photoelectric switch includes a semiconductor laser (1), a photodiode (2), and a distance determination processing unit (20). The semiconductor laser (1) emits laser light. The photodiode (2) detects an electrical signal including an interference waveform generated by a self-mixing effect between laser light emitted from the semiconductor laser (1) and return light from an object (10) existing ahead of the semiconductor laser (1). The distance determination processing unit (20) determines, from information of an interference waveform included in an output signal from the photodiode (2), whether the object (10) is at a distance longer or shorter than a predetermined reference distance.

FIG. 1

**Description**

Background of the Invention

The present invention relates to a reflective photoelectric switch and, more particularly, to a reflective photoelectric switch which detects whether the distance to an object is longer or shorter than a predetermined reference distance and an object detection method.

As a conventional reflective photoelectric switch, a distance setting reflective (BackGround Suppression to be abbreviated as BGS hereinafter) photoelectric switch is known, which detects whether the distance from the photoelectric switch to an object is longer or shorter than a predetermined reference distance (see Japanese Patent Laid-Open Nos. 63-102135 and 63-187237). Such a BGS photoelectric switch can detect only an object without detecting any background.

As a rangefinder using interference of laser light, a laser measuring instrument using interference (a self-mixing effect) between output light from a laser and return light from a measurement target is proposed as follows:

· Tadashi Ueda, Jun Yamada, and Susumu Shitoh, "Distance Meter Using Self-Mixing Effect of Semiconductor Laser", Papers for 1994 Tokai-Section Joint Conference of the 8 Institutes of Electrical and Related Engineers, 1994
· Jun Yamada, Susumu Shitoh, Norio Tuda, and Tadashi Ueda, "Study of Compact Distance Meter by Self-Mixing Effect of Laser Diode", Bulletin of Aichi Institute of Technology, Vol. 31B, pp. 35 - 42, 1996
· Guido Giuliani, Michele Norgia, Silvano Donati and Thierry Bosch, "Laser diode self-mixing technique for sensing applications", JOURNAL OF OPTICS A: PURE AND APPLIED OPTICS, pp. 283 - 294, 2002

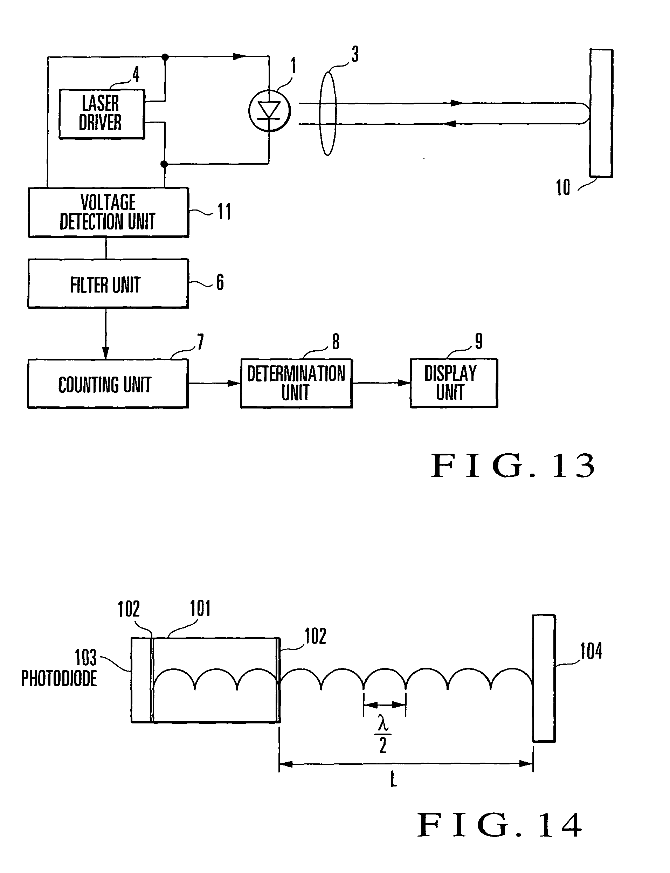

Fig. 14 shows a conventional complex cavity model of an FP type (Fabry-Perot type) semiconductor laser. Referring to Fig. 14, reference numeral 101 denotes a semiconductor laser; 102, a cleavage plane of a semiconductor crystal; 103, a photodiode; and 104, a measurement target.

Let $\lambda$ be the oscillation wavelength of the laser and L be the distance from the cleavage plane 102 near the measurement target 104 to the measurement target 104. In this case, when the following resonance condition is satisfied, return light from the measurement target 104 and laser light in the cavity 101 strengthen each other. Consequently, the laser power slightly increases.

$$L = q\lambda/2 \qquad\qquad ...(1)$$

where q is an integer. This phenomenon can be sufficiently observed even with very weak scattered light from the measurement target 104 when an amplifying action occurs as the apparent reflectance inside the semiconductor laser cavity 101 increases.

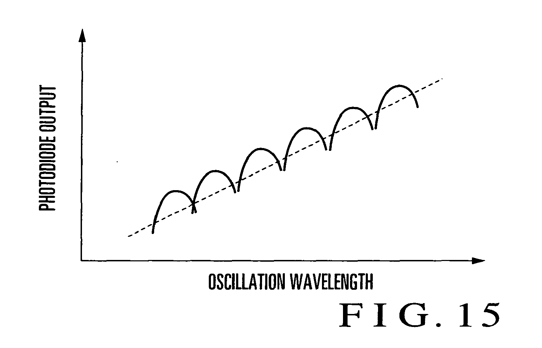

A semiconductor laser emits laser light having different frequencies in accordance with the magnitude of injection current. When modulating an oscillation frequency, this laser therefore allows direct modulation of the oscillation frequency by using an injection current without requiring any external modulator. Fig. 15 shows the relationship between the oscillation wavelength and the output waveform of the photodiode 103 when the oscillation wavelength of the semiconductor laser is changed at a predetermined rate. When $L = q\lambda/2$ indicated by equation (1) is satisfied, the phase difference between return light and laser light inside the cavity 101 becomes 0° (in phase), and the return light and the laser light inside the cavity 101 strengthen each other most. When $L = q\lambda/2 + \lambda/4$, the phase difference becomes 180° (in opposite phase), and the return light and the laser light inside the cavity 101 weaken each other most. As the oscillation wavelength of the semiconductor laser is changed, therefore, the laser power increases and decreases alternately and repeatedly. When the laser power is detected at this time by the photodiode 103 provided in the cavity 101, a stepwise waveform having a predetermined period like that shown in Fig. 15 is obtained. Such a waveform is generally called an interference fringe.

Each of the elements of this stepwise waveform, i.e., the interference fringe, is called a mode hop pulse (to be referred to as an MHP hereinafter). MHP is a phenomenon different from a mode hopping phenomenon. Assume that the distance to the measurement target 104 is represented by L1, and the number of MHPs is 10. In this case, as the distance decreases to L2 which is 1/2 of L1, the number of MHPs becomes five. That is, as the oscillation wavelength of the semiconductor laser changes in a predetermined time, the number of MHPs changes in proportion to the measurement distance. Therefore, detecting MHPs by the photodiode 103 and measuring the frequency of MHPs can easily measure the distance.

A BGS photoelectric switch can be implemented by using the above self-mixing type laser measuring instrument. It suffices to determine ON/OFF of the BGS photoelectric switch based on whether an object is at a short distance or a long distance compared with a predetermined reference distance. If a self-mixing type laser measuring instrument is to be used as a BGS photoelectric switch, it suffices to determine whether the average period of measured MHPs is longer or shorter than a known reference period of an MHP when an object is located at a reference distance. If the average period of the measured MHPs is longer than the known period of the MHP when the object is at the reference distance, it is determined that the object is located at a distance shorter than the reference distance, and ON is determined. If the average period of the measured MHPs is shorter than the known period, it is determined that the object is located at a distance longer than the reference distance, and OFF is determined.

As described above, using a self-mixing type laser measuring instrument can implement a BGS photoelectric switch. However, only comparing the simply obtained average period of MHPs with a reference period will degrade the determination accuracy. It is possible to improve the determination accuracy by using the technique proposed by the present inventor in Japanese Patent Application No. 2007-015020, i.e., obtaining the frequency distribution of the periods of MHPs, obtaining the representative value of the distribution, e.g., the median or mode, and calculating the distance to the object based on the representative value of the period distribution and the frequency distribution of the periods, and comparing the calculated distance with a reference distance. Such a method, however, requires a memory and a computer. This undesirably increases the cost of the BGS photoelectric switch.

Summary of the Invention

It is an object of the present invention to provide a high-accuracy reflective photoelectric switch with a simple, inexpensive arrangement by using a self-mixing type laser measuring instrument and an object detection method.

In order to achieve the above object, according to the present invention, there is provided a reflective photoelectric switch comprising a semiconductor laser which emits laser light, detection means for detecting an electrical signal including an interference waveform generated by a self-mixing effect between laser light emitted from the semiconductor laser and return light from an object existing ahead of the semiconductor laser, and distance determination processing means for determining, from information of an interference waveform included in an output signal from the detection means, whether the object is at a distance longer or shorter than a predetermined reference distance.

In addition, according to the present invention, there is provided an object detection method comprising the steps of driving a semiconductor laser by supplying a driving current thereto, detecting an electrical signal including an interference waveform generated by a self-mixing effect between laser light emitted from the semiconductor laser and return light from an object existing ahead of the semiconductor laser, and determining, from information of an interference waveform included in a detected electrical signal, whether a distance to the object is longer or shorter than a predetermined reference distance.

Brief Description of the Drawings

Fig. 1 is a block diagram showing the arrangement of a BGS photoelectric switch according to the first embodiment of the present invention;
Fig. 2 is a chart showing an example of a temporal change in the oscillation wavelength of a semiconductor laser according to the first embodiment of the present invention;
Figs. 3A and 3B are waveform charts schematically showing an output voltage waveform from a current/voltage conversion amplifying unit and an output voltage waveform from a filter unit in the first embodiment of the present invention;
Fig. 4 is a graph showing the relationship between the distance to an object and the frequency distribution of the periods of mode hop pulses in the first embodiment of the present invention;
Fig. 5 is a block diagram showing the arrangement of the counting unit of a BGS photoelectric switch according to the second embodiment of the present invention;
Fig. 6 is a waveform chart schematically showing an output voltage waveform from a filter unit in the second embodiment of the present invention;
Fig. 7 is a waveform chart schematically showing an output voltage waveform from the filter unit at the timing of the maximal value of a triangular wave;
Fig. 8 is a block diagram showing the arrangement of the counting unit of a BGS photoelectric switch according to the third embodiment of the present invention;
Fig. 9 is a waveform chart schematically showing an output voltage waveform from a filter unit in the third embodiment of the present invention;
Fig. 10 is a waveform chart for explaining a problem in the counting unit of the BGS photoelectric switch according to the third embodiment of the present invention;
Fig. 11 is a graph showing an example of the frequency distribution of the half periods of mode hop pulses in a case in which mode hop pulses include DC biases in the third embodiment of the present invention;
Fig. 12 is a waveform chart schematically showing an output voltage waveform from a filter unit at the timing of the minimal value of a triangular wave;
Fig. 13 is a block diagram showing the arrangement of a BGS photoelectric switch according to the fifth embodiment of the present invention;
Fig. 14 is a view showing a complex cavity model of a semiconductor laser in a conventional laser measuring instrument; and
Fig. 15 is a graph showing the relationship between the oscillation wavelength of the semiconductor laser and an output waveform from a built-in photodiode.

Description of the Preferred Embodiments

[First Embodiment]

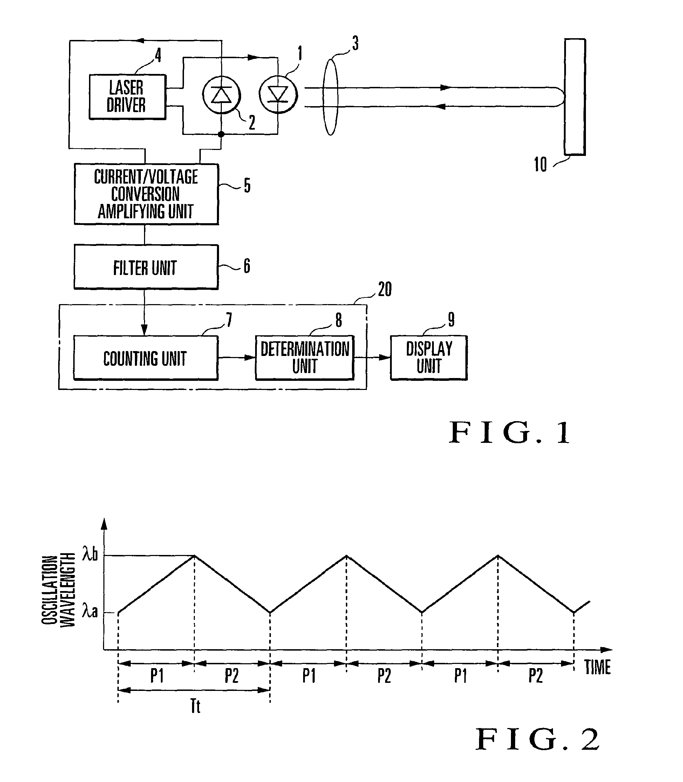

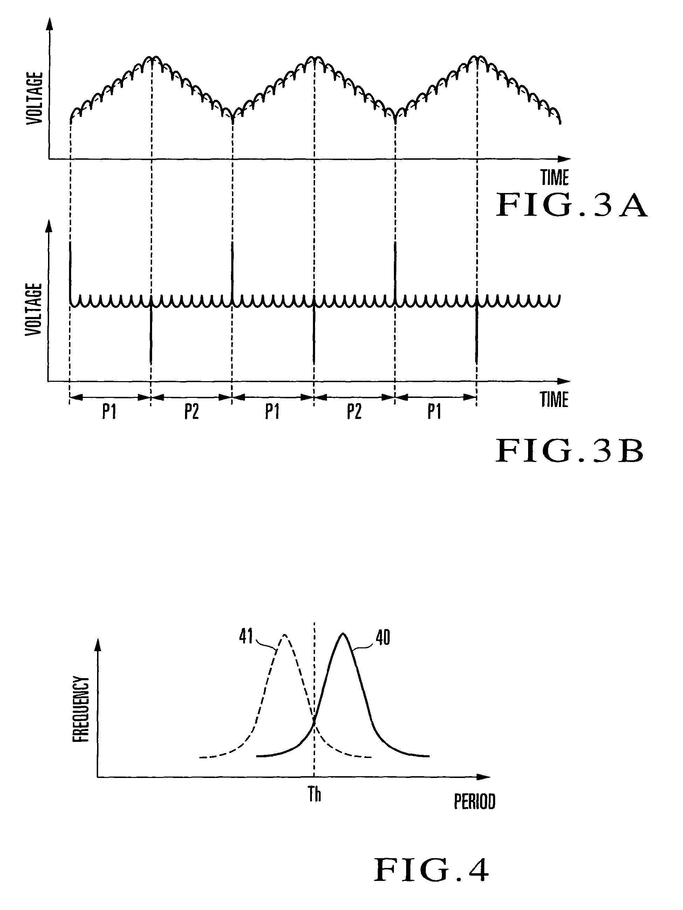

The first embodiment of the present invention will be described below with reference to the accompanying drawings. Fig. 1 shows the arrangement of a BGS photoelectric switch according to the first embodiment of the present invention. The BGS photoelectric switch in Fig. 1 includes a semiconductor laser 1 which emits laser light, a photodiode 2 which converts an optical output from the semiconductor laser 1 into an electrical signal, a lens 3 which focuses light from the semiconductor laser 1 to radiate it and also focuses return light from an object 10 to make it strike the semiconductor laser 1, a laser driver 4 which drives the semiconductor laser 1, a current/voltage conversion amplifying unit 5 which converts an output current from the photodiode 2 into a voltage and amplifies it, a filter unit 6 which removes a carrier wave from an output voltage from the current/voltage conversion amplifying unit 5, a counting unit 7 which counts the number of MHPs contained in an output voltage from the filter unit 6, a determination unit 8 which determines from the counting result obtained by the counting unit 7 whether the object 10 is at a distance shorter or longer than a predetermined reference distance, and a display unit 9 which displays the determination result obtained by the determination unit 8.
The photodiode 2 and the current/voltage conversion amplifying unit 5 constitute a detection means. The filter unit 6, the counting unit 7, and the determination unit 8 constitute a distance determination processing unit 20. For easy description, assume that as the semiconductor laser 1, a type (VCSEL type or DFB laser type) of laser which has no mode hopping phenomenon is used.
The laser driver 4 supplies, to the semiconductor laser 1, a triangular wave driving current which repeatedly increases and decreases at a constant change rate with respect to time as an injection current. With this operation, the semiconductor laser 1 is driven to alternately repeat the first oscillation interval in which the oscillation wavelength continuously increases at a constant change rate in proportion to the magnitude of an injection current and the second oscillation interval in which the oscillation wavelength continuously decreases at a constant change rate.
Fig. 2 shows a temporal change in the oscillation wavelength of the semiconductor laser 1. Referring to Fig. 2, reference symbol P1 denotes the first oscillation interval; P2, the second oscillation interval; λa, the minimum value of the oscillation wavelength in each interval; λb, the maximum value of the oscillation wavelength in each interval; and Tt, the period of a rectangular wave. In this embodiment, the maximum value λb and minimum value λa of the oscillation wavelength are kept constant, and a difference λb - λa between them is also kept constant.
The laser light emitted from the semiconductor laser 1 is focused by the lens 3 and strikes the object 10. The light reflected by the object 10 is focused by the lens 3 and strikes the semiconductor laser 1. It is not, however, essential that the lens 3 focuses light. The photodiode 2 is placed inside or near the semiconductor laser 1 and converts an optical output from the semiconductor laser 1 into a current. The current/voltage conversion amplifying 5 converts an output current from the photodiode 2 into a voltage and amplifies it.
The filter unit 6 has a function of extracting a superimposed signal from a modulated wave. Fig. 3A schematically shows an output voltage waveform from the current/voltage conversion amplifying unit 5. Fig. 3B schematically shows an output voltage waveform from the filter unit 6. Figs. 3A and 3B show the process of extracting the MHP waveform (interference waveform) in Fig. 3B by removing the oscillation waveform (carrier wave) of the semiconductor laser 1 in Fig. 2 from the waveform (modulated wave) in Fig. 3A which corresponds to an output from the photodiode 2.
The counting unit 7 counts the number of MHPs contained in an output voltage from the filter unit 6, more specifically, a number Nlong of MHPs having periods longer than the known period of an MHP (to be referred to as a reference period Th hereinafter) when the object 10 is at a predetermined reference distance and a number Nshort of MHPs having periods shorter than the reference period Th, in each of the first oscillation interval P1 and the second oscillation interval P2.
When the distance per MHP, the reference distance, and the frequency of a triangular wave are 0.5 mm, 200 mm, and 1 kHz, respectively, the number of MHPs to be measured corresponds to the distance [mm] to the object 10 divided by 0.5 [mm]. When, therefore, the object 10 is at a position spaced apart from the BGS photoelectric switch by the reference distance, the number of MHPs is 200 [mm] /0.5 [mm] = 400. At this time, the reference period Th of an MHP is 1/(1000 x 2)/400 = 1.25 [μs]. If the distance to the object 10 is longer than the reference distance, the period of an MHP becomes shorter than reference period Th = 1.25 [μs].

If the distance to the object 10 is shorter than the reference distance, the period of an MHP becomes longer than reference period Th = 1.25 [μs].

If the object 10 is at a distance shorter than the reference distance, the distribution of the periods of MHPs shifts to the side where periods are longer than the reference period Th, as indicated by a distribution 40 in Fig. 4. In contrast to this, if the object 10 is at a distance longer than the reference distance, the distribution of the periods of MHPs shifts to the side where periods are shorter than the reference period Th, as indicated by a distribution 41 in Fig. 4.

The determination unit 8 determines from the counting result obtained by the counting unit 7 whether the object 10 is at a distance shorter or longer than the reference distance. That is, the determination unit 8 compares the number Nlong of MHPs having periods longer than the reference period Th with the number Nshort of MHPs having periods shorter than the reference period Th. If Nlong > Nshort holds, the determination unit 8 determines that the object 10 is at a distance shorter than the reference distance. If Nlong < Nshort holds, the determination unit 8 determines that the object 10 is at a distance longer than the reference distance.

The determination unit 8 performs the above determination for each counting interval (each of the first oscillation interval P1 and the second oscillation interval P2 in this embodiment) in which the counting unit 7 counts the number of MHPs. The display unit 9 displays the determination result obtained by the determination unit 8.

As described above, in this embodiment, by comparing the number Nlong of MHPs having periods longer than the reference period Th with the number Nshort of MHPs having periods shorter than the reference period Th, it is possible to determine whether the distance from the BGS photoelectric switch to the object 10 (more accurately, the distance from the semiconductor laser 1 to the object 10) is longer or shorter than the reference distance. This makes it possible to implement a high-accuracy BGS photoelectric switch with a simple, inexpensive arrangement.

Note that the counting unit 7 and the determination unit 8 can be implemented by a computer including a CPU, storage device, and interface and programs stored in the storage device or hardware. In this embodiment, the number Nlong of MHPs having periods longer than the reference period Th is compared with the number Nshort of MHPs having periods shorter than the reference period Th. However, it suffices to compare the number of MHPs having half periods longer than a half period Th/2 (to be referred to as a reference half period Th/2 hereinafter) of the reference period with the number of MHPs having half periods shorter than the reference half period Th/2. A case in which the reference half period Th/2 is used will be described later.

[Second Embodiment]

The second embodiment of the present invention will be described next. This embodiment describes the counting unit 7 in the first embodiment in more detail.

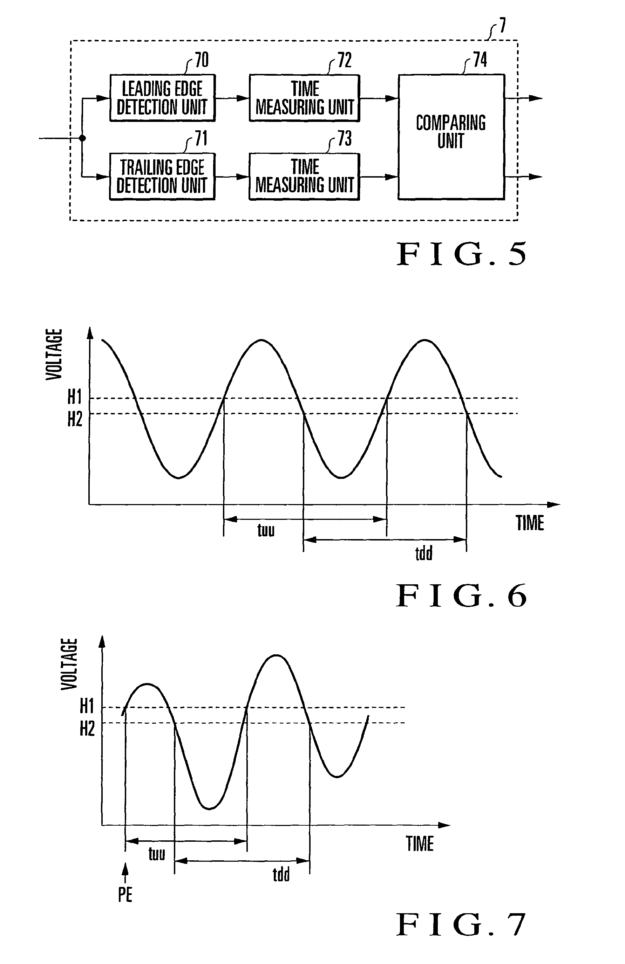

Fig. 5 shows the arrangement of the counting unit of a BGS photoelectric switch according to the second embodiment of the present invention. A counting unit 7 in this embodiment includes a leading edge detection unit 70, a trailing edge detection unit 71, time measuring units 72 and 73, and a comparing unit 74.

Fig. 6 explains the operation of the counting unit 7 in this embodiment, and schematically shows an output voltage waveform from a filter unit 6, i.e., the waveform of an MHP. Referring to Fig. 6, reference symbol H1 denotes a threshold for detecting the leading edge of an MHP; and H2, a threshold for detecting the trailing edge of an MHP. The leading edge detection unit 70 detects the leading edge of an MHP by comparing an output voltage from the filter unit 6 with the threshold H1. The time measuring unit 72 measures a time tuu from the leading edge of an MHP to the next leading edge based on the detection result obtained by the leading edge detection unit 70. The time measuring unit 72 performs such measurement every time the leading edge of an MHP is detected.

The trailing edge detection unit 71 detects the trailing edge of an MHP by comparing an output voltage from the filter unit 6 with the threshold H2. The time measuring unit 73 measures a time tdd from the trailing edge of an MHP to the next trailing edge based on the detection result obtained by the trailing edge detection unit 71. The time measuring unit 73 performs such measurement every time the trailing edge of an MHP is detected.

The comparing unit 74 compares the time tuu from the leading edge of an MHP to the next leading edge with the reference period Th. If the time tuu is longer than the reference period Th, the comparing unit 74 increments by one the number Nlong of MHPs having periods longer than the reference period Th. If the time tuu is shorter than the reference period Th, the comparing unit 74 increments by one the number Nshort of MHPs having periods shorter than the reference period Th. The comparing unit 74 performs such counting operation every time the time tuu is measured.

Alternatively, the comparing unit 74 can perform measurement in the following manner by using the time tdd from the trailing edge of an MHP to the next trailing edge. The comparing unit 74 compares the time tdd from the trailing edge of an MHP to the next trailing edge with the reference period Th. If the time tdd is longer than the reference period Th, the comparing unit 74 increments by one the number Nlong of MHPs having periods longer than the reference period Th. If the time tdd is shorter than the reference period Th, the comparing unit 74 increments by one the number Nshort of MHPs having periods shorter than the reference period Th. The comparing unit 74 performs such counting operation every time the time tdd is measured.

In the above manner, the counting unit 7 in this embodiment can count the number Nlong of MHPs having periods longer than the reference period Th and the number Nshort of MHPs having periods shorter than the reference period Th. As described in the first embodiment, the counting unit 7 counts MHPs in each counting interval (each of the first oscillation interval P1 and the second oscillation interval P2).

Note that when the comparing unit 74 is to use the time tuu, the trailing edge detection unit 71 and the time measuring unit 73 are not essential components. When the comparing unit 74 is to use the time tdd, the leading edge detection unit 70 and the time measuring unit 72 are not essential components. The other components of the BGS photoelectric switch are the same as those described in the first embodiment.

In this embodiment, since it suffices to perform only detection of the leading edges (trailing edges) of MHPs and comparison between the lengths of periods, the counting unit 7 can be implemented by a simple arrangement. This embodiment, however, has the following problem. That is, in the case of a self-mixing type laser measuring instrument used as a BGS photoelectric switch, since the oscillation wavelength of the semiconductor laser 1 is changed in the form of a triangular wave, it is impossible to completely remove the influence of a transient response at the vertex of a triangular wave. For this reason, there is a possibility that the period of an MHP may be measured to be longer or shorter than the actual period. This may cause an error in a counting result, resulting in an error in the determination on whether the object 10 is at a long or short distance.

That is, the filter unit 6 extracts an MHP waveform like that shown in Fig. 3B by removing the oscillation waveform (carrier wave) of a semiconductor laser 1 from an output voltage waveform (modulated waveform) from a current/voltage conversion amplifying unit 5. At this time, a transient response waveform in the form of a spike appears in an output from the filter unit 6 at the timing of the vertex of a triangular wave. An error occurs in the measurement of the period of an MHP due to this transient response waveform.

This problem will be described with reference to Fig. 7. Referring to Fig. 7, a point PE indicates the timing of the maximal value of a triangular wave.

As shown in Fig. 3B, at the timing of the maximal value of the triangular wave, downward spike nozzle occurs in an output from the filter unit 6, and hence the waveform of the MHP is pulled in the direction in which the voltage drops, as shown in Fig. 7. For this reason, the time tuu from the leading edge of the MHP to the next leading edge becomes shorter than the proper time, and the time tdd from the trailing edge of the MHP to the next trailing edge becomes longer than the proper time. Such a problem can be improved by causing the counting unit 7 and the determination unit 8 to perform the above operation in a time corresponding to one period of a triangular wave. If a DC bias exists in an MHP, the transient response at the timing of the maximal value of a triangular wave differs from the transient response at the timing of the minimal value of the triangular wave. As a consequence, the influence of the response difference remains.

[Third Embodiment]

The third embodiment of the present invention will be described next. This embodiment will exemplify a case in which the BGS photoelectric switch of the first embodiment uses a reference half period Th/2.

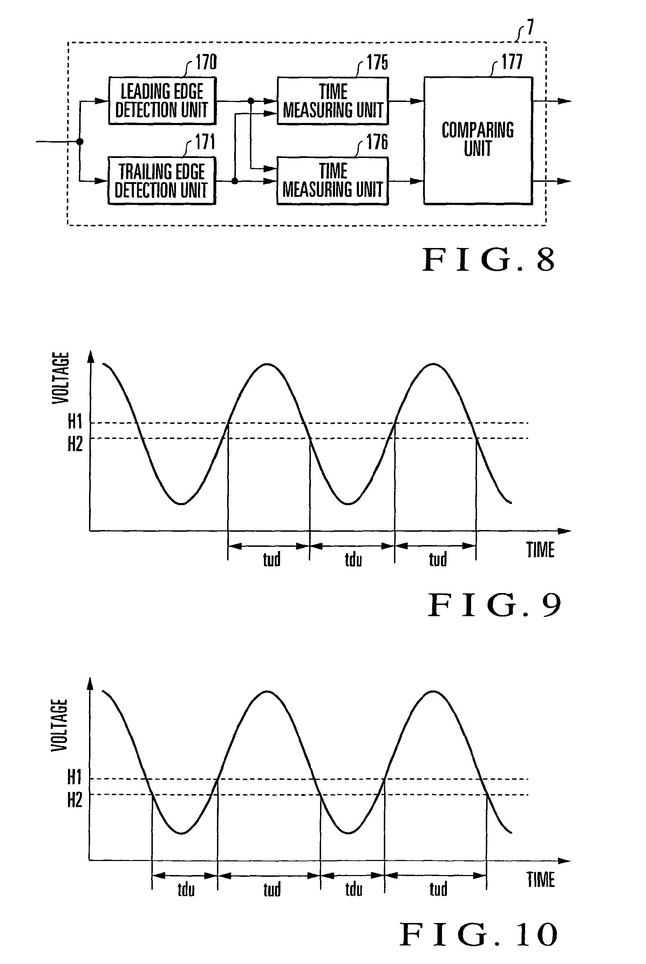

Fig. 8 shows the arrangement of the counting unit of a BGS photoelectric switch according to the third embodiment of the present invention. A counting unit 7 in this embodiment includes a leading edge detection unit 170, a trailing edge detection unit 171, time measuring units 175 and 176, and a comparing unit 177.

Fig. 9 explains the operation of the counting unit 7 in this embodiment and schematically shows an output voltage waveform from a filter unit 6, i.e., the waveform of an MHP. The operations of the leading edge detection unit 170 and trailing edge detection unit 171 are the same as those in the second embodiment.

The time measuring unit 175 measures a time tud from the leading edge of an MHP to the next trailing edge based on the detection results obtained by the leading edge detection unit 170 and the trailing edge detection unit 171. The time measuring unit 175 performs such measurement every time the leading edge and trailing edge of an MHP are detected. The time measuring unit 176 measures a time tdu from the trailing edge of an MHP to the next leading edge based on the detection results obtained by the leading edge detection unit 170 and the trailing edge detection unit 171. The time measuring unit 176 performs such measurement every time the trailing edge and leading edge of an MHP are detected.

The comparing unit 177 compares the time tud from the leading edge of an MHP to the next trailing edge and the time tdu from the trailing edge of an MHP to the next leading edge with the reference half period Th/2. If the time tud is longer than the reference half period Th/2 or the time tdu is longer than the reference half period Th/2, the comparing unit 177 increments by one a number Nlong of MHPs having half periods longer than the reference half period Th/2. If the time tud is shorter than the reference half period Th/2 or the time tdu is shorter than the reference half period Th/2, the comparing unit 177 increments by one a number Nshort of MHPs having half periods shorter than the reference half period Th/2. The comparing unit 177 performs such counting operation every time the time tud or tdu is measured.

In the above manner, the counting unit 7 in this embodiment can count the number Nlong of MHPs having half periods longer than the reference half period Th/2 and the number Nshort of MHPs having half periods shorter than the reference half period Th/2. As described in the first embodiment, the counting unit 7 counts MHPs in each counting interval (each of a first oscillation interval P1 and a second oscillation interval P2).

In this embodiment, a determination unit 8 compares the number Nlong of MHPs having half periods longer than the reference half period Th/2 with the number Nshort of MHPs having half periods shorter than the reference period Th/2. If Nlong > Nshort holds, the determination unit 8 determines that an object 10 is at a distance shorter than the reference distance. If Nlong < Nshort holds, the determination unit 8 determines that the object 10 is at a distance longer than the reference distance. The other components of the BGS photoelectric switch are the same as those described in the first embodiment.

In addition to the effects of the second embodiment, the third embodiment can improve the counting accuracy because the number of values counted is doubled, thereby improving the determination accuracy for the distance to the object 10. However, this embodiment has the following problem. That is, when a DC bias exists in an MHP, it is difficult to determine whether the object 10 is at a distance longer or shorter than the reference distance.

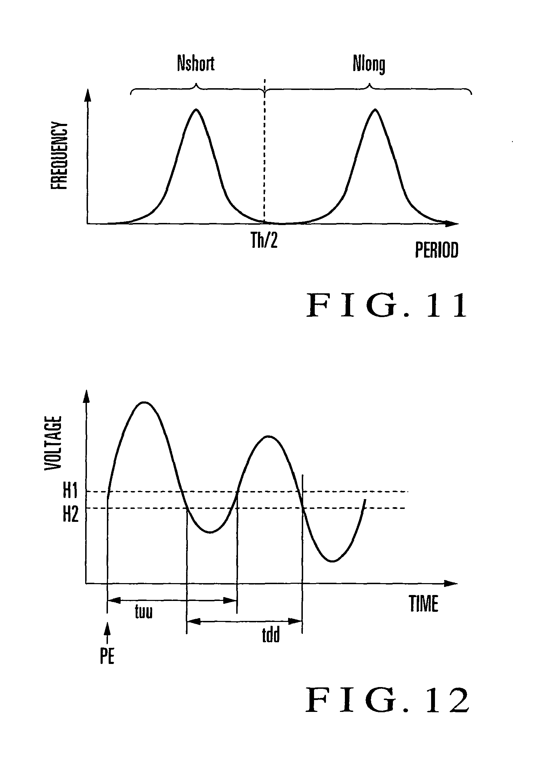

This problem will be described with reference to Figs. 10 and 11. Fig. 10 shows a case in which the average voltage of MHPs is higher than the proper voltage due to a DC bias. As shown in Fig. 10, if a DC bias exists in an MHP, since the MHP is not properly divided into 1/2 at the leading edge and the trailing edge, the time tud from the leading edge of the MHP to the next trailing edge becomes longer than the proper time. The time tdu from the trailing edge of the MHP to the next leading edge becomes longer than the proper time.

The distribution of half periods of MHPs is an overlap of two normal distributions line-symmetrical about the reference half period Th/2, as shown in Fig. 11. That is, the number Nlong of MHPs having half periods longer than the reference half period Th/2 becomes almost equal to the number Nshort of MHPs having half periods shorter than the reference half period Th/2. As a consequence, an error occurs in a counting result on MHPs, it may be erroneously determined that Nlong > Nshort. In some cases, it may be erroneously determined that Nlong < Nshort. This makes it difficult to properly determine whether the object 10 is at a distance longer or shorter than the reference distance.

[Fourth Embodiment]

The fourth embodiment of the present invention will be described next. This embodiment will describe the counting unit 7 in the first embodiment more concretely. The arrangement of a counting unit 7 in this embodiment is the same as that in the second embodiment, and hence will be described by using the same reference numerals as those in Fig. 5. The operations of a leading edge detection unit 70, trailing edge detection unit 71, and time measuring units 72 and 73 are the same as those in the second embodiment.

A comparing unit 74 in this embodiment compares a time tuu from the leading edge of an MHP to the next leading edge and a time tdd from the trailing edge of the MHP to the next trailing edge with a reference period Th described above. If the time tuu is longer than the reference period Th or the time tdd is longer than the reference period Th, the comparing unit 74 increments by one a number Nlong of MHPs having periods longer than the reference period Th. If the time tuu is shorter than the reference period Th or the time tdd is shorter than the reference period Th, the comparing unit 74 increments by one a number Nshort of MHPs having periods shorter than the reference period Th. The comparing unit 74 performs such counting operation every time either the time tuu or the time tdd is measured.

In the above manner, the counting unit 7 in this embodiment can count the number Nlong of MHPs having periods longer than the reference period Th and the number Nshort of MHPs having periods shorter than the reference period Th. As described in the first embodiment, the counting unit 7 counts MHPs in each counting interval (each of the first oscillation interval P1 and the second oscillation interval P2). The other components of the BGS photoelectric switch are the same as those described in the first embodiment.

In addition to the effects of the third embodiments, the fourth embodiment can reduce the influence of a transient response at the vertex of a triangular wave on a counting result, and hence can solve the problem described in the second embodiment.

As described with reference to Fig. 7, at the timing of the vertex of a triangular wave, the waveform of the MHP is pulled in the direction in which the voltage drops. For this reason, the time tuu from the leading edge of an MHP to the next leading edge becomes shorter than the proper time, and the tdd from the trailing edge of an MHP to the next trailing edge becomes longer than the proper time.

Fig. 12 shows a case in which a point PE indicates the timing of the minimal value of a triangular wave. As shown in Fig. 3B, at the timing of the minimal value of a triangular wave, since upward spike noise occurs in an output from a filter unit 6, the waveform of the MHP is pulled in the direction in which the voltage rises, as shown in Fig. 12. For this reason, the time tuu from the leading edge of an MHP to the next leading edge becomes longer than the proper time, and the tdd from the trailing edge of an MHP to the next trailing edge becomes shorter than the proper time.

In either of the cases shown in Figs. 7 and 12, the number of MHPs having periods longer than the proper period becomes equal to the number of MHPs having periods shorter than the proper period due to the influence of a transient response. Therefore, both the number Nlong of MHPs having periods longer than the reference period Th and the Nshort of MHPs having periods shorter than the reference period Th increase or decrease by the same number. This can cancel out a change in counting result due to a transient response and hence can reduce the influence of a transient response at the vertex of a triangular wave on a counting result.

In this embodiment, even when a DC bias exists in an MHP, since the time tuu from the leading edge of the MHP to the next leading edge and the time tdd from the trailing edge of the MHP to the next trailing edge do not change, the influence of the DC bias on the MHP can be eliminated. This can solve the problem described in the third embodiment.

[Fifth Embodiment]

In the first to fourth embodiments, although an MHP waveform is extracted from an output signal from a photodiode serving as a photoreceiver, it is possible to extract an MHP waveform without using any photodiode. Fig. 13 shows the arrangement of a BGS photoelectric switch according to the fifth embodiment of the present invention. The same reference numerals as in Fig. 1 denote the same components in Fig. 13. The BGS photoelectric switch of this embodiment uses a voltage detection unit 11 instead of the photodiode 2 and the current/voltage conversion amplifying unit 5 in the first to fourth embodiments.

The voltage detection unit 11 detects and amplifies the inter-terminal voltage of a semiconductor laser 1, i.e., the voltage between the anode and the cathode. When the laser light emitted from the semiconductor laser 1 interferes with return light from an object 10, an MHP waveform appears in the inter-terminal voltage of the semiconductor laser 1. It is therefore possible to extract the MHP waveform from the inter-terminal voltage of the semiconductor laser 1.

The filter unit 6 has a function of extracting a superimposed signal from a modulated wave as in the first to fourth embodiments, and extracts an MHP waveform from an output voltage from the voltage detection unit 11. The operations of the semiconductor laser 1, a laser driver 4, a counting unit 7, a determination unit 8, and a display unit 9 are the same as those in the first to fourth embodiments.

In this manner, this embodiment can extract an MHP waveform without using any photodiode, and hence can reduce the number of the parts of the BGS photoelectric switch as compared with the first to fourth embodiments. This makes it possible to reduce the cost of the BGS photoelectric switch.

According to the present invention, a high-accuracy reflective photoelectric switch can be implemented with a simple, inexpensive arrangement by using a self-mixing type laser measuring instrument. In addition, a counting means can be implemented by a simple arrangement. Improving counting accuracy can improve determination accuracy for the distance to an object. Furthermore, it is possible to reduce the influence of the transient response of the oscillation waveform of a semiconductor laser on a counting result. It is also possible to eliminate the influence of a DC bias on an interference waveform.

**Claims**

1. A reflective photoelectric switch **characterized by** comprising:

    a semiconductor laser (1) which emits laser light;
    detection means (2) for detecting an electrical signal including an interference waveform generated by a self-mixing effect between laser light emitted from said semiconductor laser and return light from an object (10) existing ahead of said semiconductor laser; and
    distance determination processing means (20) for determining, from information of an interference waveform included in an output signal from said detection means, whether the object is at a distance longer or shorter than a predetermined reference distance.

2. A switch according to claim 1, wherein the distance determination processing means comprises
    counting means (7) for counting the number of interference waveforms included in an output signal from said detection means by separately counting the number of interference waveforms having periods longer than a reference period and the number of interference waveforms having periods shorter than the reference period, with the reference period being a period of an interference waveform when the object is at the reference distance, and
    determination means (8) for determining that the object exists at a distance shorter than the reference distance, when the number of interference waveforms having periods longer than the reference period is larger than the number of interference waveforms having periods shorter than the reference period, and determining that that the object exists at a distance longer than the reference distance, when the number of interference waveforms having periods shorter than the reference period is larger than the number of interference waveforms having periods longer than the reference period.

3. A switch according to claim 1, wherein the distance determination processing means comprises
counting means (7) for counting the number of interference waveforms included in an output signal from said detection means by separately counting the number of interference waveforms having half periods longer than a reference half period and the number of interference waveforms having half periods shorter than the reference half period, with the reference half period being a half period of an interference waveform when the object is at the reference distance, and
determination means (8) for determining that the object exists at a distance shorter than the reference distance, when the number of interference waveforms having half periods longer than the reference half period is larger than the number of interference waveforms having half periods shorter than the reference half period, and determining that that the object exists at a distance longer than the reference distance, when the number of interference waveforms having half periods shorter than the reference half period is larger than the number of interference waveforms having half periods longer than the reference half period.

4. A switch according to claim 2, wherein the counting means comprises
leading edge detection means (70) for detecting a leading edge of an interference waveform,
time measuring means (72) for measuring a time from a leading edge of an interference waveform to a next leading edge, and
comparing means (74) for increasing the number of interference waveforms having periods longer than the reference period when the time from the leading edge of the interference waveform to the next leading edge is longer than the reference period, and increasing the number of interference waveforms having periods shorter than the reference period when the time from the leading edge of the interference waveform to the next leading edge is shorter than the reference period.

5. A switch according to claim 2, wherein the counting means comprises
trailing edge detection means (71) for detecting a trailing edge of an interference waveform,
time measuring means (73) for measuring a time from a trailing edge of an interference waveform to a next trailing edge, and
comparing means (74) for increasing the number of interference waveforms having periods longer than the reference period when the time from the trailing edge of the interference waveform to the next trailing edge is longer than the reference period, and increasing the number of interference waveforms having periods shorter than the reference period when the time from the trailing edge of the interference waveform to the next trailing edge is shorter than the reference period.

6. A switch according to claim 2, wherein the counting means comprises
leading edge detection means (70) for detecting a leading edge of an interference waveform,
trailing edge detection means (71) for detecting a trailing edge of an interference waveform,
first time measuring means (72) for measuring a first time from a leading edge of an interference waveform to a next leading edge,
second time measuring means (73) for measuring a second time from a trailing edge of an interference waveform to a next trailing edge, and
comparing means (74) for increasing the number of interference waveforms having periods longer than the reference period when the first time is longer than the reference period or the second time is longer than the reference period, and increasing the number of interference waveforms having periods shorter than the reference period when the first time is shorter than the reference period or the second time is shorter than the reference period.

7. A switch according to claim 3, wherein the counting means comprises
leading edge detection means (170) for detecting a leading edge of an interference waveform,
trailing edge detection means (171) for detecting a trailing edge of an interference waveform;
first time measuring means (175) for measuring a first time from a leading edge of an interference waveform to a next trailing edge,
second time measuring means (176) for measuring a second time from a trailing edge of an interference waveform to a next leading edge, and
comparing means (177) for increasing the number of interference waveforms having half periods longer than the reference half period when the first time is longer than the reference half period or the second time is longer than the reference half period, and increasing the number of interference waveforms having half periods shorter than the reference half period when the first time is shorter than the reference half period or the second time is shorter than the reference half period.

**8.** An object detection method **characterized by** comprising the steps of:

driving a semiconductor laser (1) by supplying a driving current thereto;
detecting an electrical signal including an interference waveform generated by a self-mixing effect between laser light emitted from the semiconductor laser and return light from an object (10) existing ahead of the semiconductor laser; and
determining, from information of an interference waveform included in a detected electrical signal, whether a distance to the object is longer or shorter than a predetermined reference distance.

**9.** A method according to claim 8, wherein the step of determining comprises the steps of
counting the number of interference waveforms included in a detected electrical signal by separately counting the number of interference waveforms having periods longer than a reference period and the number of interference waveforms having periods shorter than the reference period, with the reference period being a period of an interference waveform when the object is at the reference distance, and
determining that the object exists at a distance shorter than the reference distance, when the number of interference waveforms having periods longer than the reference period is larger than the number of interference waveforms having periods shorter than the reference period, and determining that that the object exists at a distance longer than the reference distance, when the number of interference waveforms having periods shorter than the reference period is larger than the number of interference waveforms having periods longer than the reference period.

**10.** A method according to claim 8, wherein the step of determining comprises the steps of
counting the number of interference waveforms included in a detected electrical signal by separately counting the number of interference waveforms having half periods longer than a reference half period and the number of interference waveforms having half periods shorter than the reference half period, with the reference half period being a half period of an interference waveform when the object is at the reference distance, and
determining that the object exists at a distance shorter than the reference distance, when the number of interference waveforms having half periods longer than the reference half period is larger than the number of interference waveforms having half periods shorter than the reference half period, and determining that that the object exists at a distance longer than the reference distance, when the number of interference waveforms having half periods shorter than the reference half period is larger than the number of interference waveforms having half periods longer than the reference half period.

FIG. 1

FIG. 2

FIG.3A

FIG.3B

FIG.4

**F I G. 5**

**F I G. 6**

**F I G. 7**

FIG. 8

FIG. 9

FIG. 10

Nshort        Nlong

FREQUENCY

Th/2

PERIOD

# FIG. 11

VOLTAGE

H1

H2

tuu

tdd

PE

TIME

# FIG. 12

FIG. 13

FIG. 14

FIG. 15

Europäisches
Patentamt

European
Patent Office

Office européen
des brevets

# EUROPEAN SEARCH REPORT

Application Number

EP 09 00 6286

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | CHRISTIAN M VON DER LIPPE ET AL: "ADVANCED OPTICAL FUZING TECHNOLOGY" PROCEEDINGS OF THE SPIE - THE INTERNATIONAL SOCIETY FOR OPTICAL ENGINEERING, SPIE, US, vol. 5871, no. 1, 1 January 2005 (2005-01-01), pages 58710I-1, XP007910388 ISSN: 0277-786X * abstract * * Chapters 1, 5 * ----- | 1,8 | INV. G01S7/491 G01S17/32 H03K17/94 |
| Y | EP 1 953 567 A2 (YAMATAKE CORP [JP]) 6 August 2008 (2008-08-06) * abstract; claims 1,5; figures 1,3A,3B * * paragraphs [0004], [0019] - [0026] * ----- | 1,8 | |
| Y | US 4 564 756 A (JOHNSON MARK [US]) 14 January 1986 (1986-01-14) * abstract * * column 1, lines 14-39 * * column 2, line 31 - column 3, line 11 * ----- | 1,8 | |
| X | DE 39 43 470 A1 (THIESSEN RAINER [DE]) 13 December 1990 (1990-12-13) * column 1, lines 3-12 * * column 5, lines 45-55 * * column 7, lines 35-58 * ----- | 1,8 | TECHNICAL FIELDS SEARCHED (IPC) G01S H03K |
| X | JP 2007 108122 A (YAMATAKE CORP) 26 April 2007 (2007-04-26) * abstract * * paragraphs [0001], [0003], [0004], [0013] * ----- | 1,8 | |

The present search report has been drawn up for all claims

| Place of search | Date of completion of the search | Examiner |
|---|---|---|
| Munich | 9 November 2009 | Grübl, Alexander |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

...............................................................................

& : member of the same patent family, corresponding
  document

EPO FORM 1503 03.82 (P04C01)

**EP 2 251 708 A1**

## ANNEX TO THE EUROPEAN SEARCH REPORT
## ON EUROPEAN PATENT APPLICATION NO.

EP 09 00 6286

This annex lists the patent family members relating to the patent documents cited in the above-mentioned European search report.
The members are as contained in the European Patent Office EDP file on
The European Patent Office is in no way liable for these particulars which are merely given for the purpose of information.

09-11-2009

| Patent document cited in search report | | Publication date | Patent family member(s) | | Publication date |
|---|---|---|---|---|---|
| EP 1953567 | A2 | 06-08-2008 | KR 20080070545 A<br>US 2008181354 A1 | | 30-07-2008<br>31-07-2008 |
| US 4564756 | A | 14-01-1986 | DE 3478840 D1<br>EP 0149123 A2<br>JP 1638510 C<br>JP 3001625 B<br>JP 60147670 A | | 03-08-1989<br>24-07-1985<br>31-01-1992<br>11-01-1991<br>03-08-1985 |
| DE 3943470 | A1 | 13-12-1990 | US 5097476 A | | 17-03-1992 |
| JP 2007108122 | A | 26-04-2007 | NONE | | |

For more details about this annex : see Official Journal of the European Patent Office, No. 12/82

# EP 2 251 708 A1

## Patent documents cited in the description

- JP 63102135 A
- JP 63187237 A
- JP 2007015020 A

## Non-patent literature cited in the description

- **Tadashi Ueda ; Jun Yamada ; Susumu Shitoh.** Distance Meter Using Self-Mixing Effect of Semiconductor Laser. *Papers for 1994 Tokai-Section Joint Conference of the 8 Institutes of Electrical and Related Engineers,* 1994
- **Jun Yamada ; Susumu Shitoh ; Norio Tuda ; Tadashi Ueda.** Study of Compact Distance Meter by Self-Mixing Effect of Laser Diode. *Bulletin of Aichi Institute of Technology,* 1996, vol. 31B, 35-42
- **Guido Giuliani ; Michele Norgia ; Silvano Donati ; Thierry Bosch.** Laser diode self-mixing technique for sensing applications. *JOURNAL OF OPTICS A: PURE AND APPLIED OPTICS,* 2002, 283-294